# EUROPEAN PATENT APPLICATION

(11) **EP 4 685 851 A1**
(43) Date of publication of application: **28.01.2026**
(21) Application number: 24774467.5
(22) Date of filing: 02.02.2024
(51) Int. Cl.: H01L 27/12, C30B 29/06, H01L 21/02, H01L 21/20, H01L 21/205, H01L 21/324

(54) **EPITAXIAL WAFER, SOI WAFER, AND METHOD FOR MANUFACTURING SAME**

(30) Priority: 22.03.2023 JP 2023045162
(71) Applicant: Shin-Etsu Handotai Co., Ltd., Tokyo 100-0004 (JP)
(72) Inventor: IKIGAKI, Ken, Annaka-shi, Gunma 379-0196 (JP); SUZUKI, Atsushi, Nishishirakawa-gun, Fukushima 961-8061 (JP)
(74) Representative: Schicker, Silvia
(86) International application number: PCT/JP2024/003588
(87) International publication number: WO 2024/195321

(57) **Abstract**

The present invention is an epitaxial wafer including a silicon epitaxial film on a silicon single crystal substrate having a resistivity of 10 Ω·cm or more and 5000 Ω·cm or less, in which the silicon epitaxial film has a carbon atomic concentration of 5×10¹⁷ atoms/cm³ or more and less than 2×10¹⁹ atoms/cm³, and carbon defects are formed in the silicon epitaxial film. This provides the epitaxial wafer and a SOI wafer capable of more reliably reducing harmonics and which can be produced through simplified processing with fewer steps without using a high-resistivity substrate, and methods for producing them.

## Description

### TECHNICAL FIELD

The present invention relates to an epitaxial wafer, a SOI wafer, and methods for producing them.

### BACKGROUND ART

In recent years, demand for high-capacity communication is extremely high, and development of equipment for use in fifth and sixth-generation mobile communication systems (commonly known as 5G and 6G) is accelerating. These telecommunication equipment are incorporated with integrated circuits, and active devices (such as transistors) and passive devices (such as inductors) that constitute the integrated circuits are required to have high operational stability under 5G and 6G environments. In particular, high-frequency bands (from millimeter wave to sub-terahertz band) are expected to be used in these high-capacity telecommunication systems; therefore, device designs and material developments that combine excellent high-frequency characteristics with power-saving performance are socially required.

Here, when taking a look at materials required for semiconductor integrated circuits, silicon wafers produced using a CZ (Czochralski) method are sometimes employed as substrates for high-frequency integrated circuits. The silicon wafers used in these cases are required to have high substrate resistivity in order to achieve low resistivity losses and excellent high-frequency characteristics. Furthermore, in applications where more excellent high-frequency characteristics are required, wafers in which trap-rich (Trap-rich) layers are formed, as disclosed in Patent Document 1 and Patent Document 2, are commonly used. This is because it is known that when a high-frequency signal is input into a device formed on a high-resistivity substrate, an inversion layer is formed in the substrate, and this leads to a phenomenon in which resistivity thereof is changed; consequently, the trap-rich layer captures a carrier generated in the inversion layer, at a deep level, this enables to maintain high substrate resistivity.

In particular, for the passive device, a wafer is used, in which a polysilicon layer is formed as the trap-rich layer on the high-resistivity substrate. In contrast, a SOI wafer having a trap-rich layer is widely used for the active device. In a structure of such a SOI wafer, the polysilicon layer as the trap-rich layer, an oxide film as a dielectric layer, and a single-crystal silicon layer are stacked on the high-resistivity substrate in this order.

However, production of the high-resistivity substrate, such as the substrate having a resistivity of 10000 Ω·cm, which is widely used as the substrate for the high-frequency integrated circuit, poses a significant technical difficulty in controlling the resistivity, resulting in low yield. In addition, polysilicon used as the trap-rich layer involves high processing difficulty, and this leads to degradation of productivity. Furthermore, a SOI structure, in which the polysilicon is used as the trap-rich layer, has complex production processes and has a major problem in cost-related issues. Accordingly, development of techniques is required to exhibit excellent high-frequency characteristics and, in particular, reduce harmonics, in a wafer with a silicon epitaxial film formed on a silicon single crystal substrate, without a use of the high-resistivity substrate.

### CITATION LIST

### PATENT LITERATURE

Patent Document 1: JP 2015-503853 A
Patent Document 2: JP 2019-129195 A
Patent Document 3: JP 2009-164590 A

### SUMMARY OF INVENTION

### TECHNICAL PROBLEM

As described above, an epitaxial wafer and a SOI wafer have been desired, which, as a substrate for a high-frequency integrated circuit, are capable of reducing harmonics without using a high-resistivity substrate, and also replacing a polysilicon layer as a trap-rich layer. In pursuit of developing a material capable of meeting such requirements, the present inventors found that an epitaxial wafer in which a silicon epitaxial film containing a high concentration of carbon is formed on a standard resistivity substrate, as well as an SOI wafer using such an epitaxial wafer, is both promising. This can provide a substrate for a high-frequency integrated circuit that can be produced with fewer steps and a simplified processing.

However, capabilities of these wafers in reducing the harmonics do not reach a level of a wafer in which a conventional polysilicon layer is used as a trap-rich layer, and development of a wafer exhibiting superior high-frequency characteristics has been a prime task.

The present invention has been made in view of the above-described problem. An object of the present invention is to provide an epitaxial wafer and a SOI wafer capable of more reliably reducing harmonics and producing with fewer steps without using a high-resistivity substrate through simplified processing, and methods for producing them.

### SOLUTION TO PROBLEM

To solve the above problem, the inventive epitaxial wafer is an epitaxial wafer comprising a silicon epitaxial film on a silicon single crystal substrate having a resistivity of 10 Ω·cm or more and 5000 Ω·cm or less, wherein
the silicon epitaxial film has a carbon atomic concentration of 5×10¹⁷ atoms/cm³ or more and less than 2×10¹⁹ atoms/cm³, and
carbon defects are formed in the silicon epitaxial film.

With such an epitaxial wafer, the silicon epitaxial film with the carbon defects formed therein functions as a trap-rich layer and inhibits a formation of an inversion layer, which can exhibit excellent harmonic reduction capability by using the silicon single crystal substrate. Consequently, it is not always necessary to use a high-resistivity substrate, which enables production to be performed with fewer steps and processing to be simplified.

Moreover, it is preferable to use such an epitaxial wafer as a wafer for a high-frequency device, due to the excellent harmonic reduction capability thereof.

Moreover, the inventive SOI wafer preferably comprises a structure in which, on the silicon epitaxial film of the epitaxial wafer, a dielectric layer and a silicon single crystal film are formed in this order.

With such a SOI wafer, the silicon epitaxial film with the carbon defects formed therein functions as a trap-rich layer and inhibits a formation of an inversion layer, which can exhibit excellent harmonic reduction capability by using the silicon single crystal substrate. Consequently, it is not always necessary to use a high-resistivity substrate, which enables production to be performed with fewer steps and processing to be simplified.

Moreover, it is preferable to use such a SOI wafer as a wafer for a high-frequency device, due to exhibiting excellent harmonic reduction capability.

Moreover, the inventive method for producing an epitaxial wafer, the method preferably comprises:
vapor phase growing a silicon epitaxial film having a carbon atomic concentration of 5×10¹⁷ atoms/cm³ or more and less than 2×10¹⁹ atoms/cm³ under reduced pressure on a silicon single crystal substrate having a resistivity of 10 Ω·cm or more and 5000 Ω·cm or less; and
thereafter subjecting the silicon epitaxial film to heat treatment under conditions of a heat treatment temperature of 900°C or more and 1100°C or less and a heat treatment time of one hour or more and 36 hours or less, thereby forming carbon defects in the silicon epitaxial film.

According to such a method for producing an epitaxial wafer, the epitaxial wafer that exhibits excellent harmonic reduction capability can be readily produced. Moreover, it is not required to use a high-resistivity substrate, and thus, the production can be performed with fewer steps, and processing can be simplified.

Moreover, the epitaxial wafer that is produced by such a method exhibits excellent harmonic reduction capability and is therefore preferably produced as the wafer for a high-frequency device.

Here, by subjecting the epitaxial wafer having the above carbon atom concentration to heat treatment, excellent harmonic characteristics can be achieved due to effect of the silicon epitaxial film having the carbon defects formed therein. This is considered to be caused by a formation of deep levels that are formed as the carbon defects formed in the silicon epitaxial film through the heat treatment, which enhances a function of the silicon epitaxial film as a trap-rich layer to inhibit a formation of an inversion layer. Accordingly, the inventive epitaxial wafer is suitable for the wafer for a high-frequency device.

Moreover, the inventive method for producing a SOI wafer, the method preferably comprises:
producing the epitaxial wafer by the method described above; and
bonding a silicon epitaxial film of the epitaxial wafer to a silicon single crystal substrate having a dielectric layer formed on a surface, via the dielectric layer.

With such a method for producing a SOI wafer, the SOI wafer exhibiting excellent harmonic reduction capability can be readily produced. Moreover, it is not required to use a high-resistivity substrate, and thus, the production can be performed with fewer steps, and processing can be simplified.

Moreover, the SOI wafer that is produced by such a method exhibits excellent harmonic reduction capability and is therefore preferably produced as the wafer for a high-frequency device.

### ADVANTAGEOUS EFFECTS OF INVENTION

The inventive epitaxial wafer with the silicon epitaxial film in which the carbon defects are formed can reduce harmonics more significantly due to the effect of the silicon epitaxial film. It is considered that a reason for this harmonic reduction results from the function of the silicon epitaxial film having the carbon defects formed therein as a trap-rich layer, which inhibits a formation of an inversion layer. Moreover, the inventive SOI wafer having the silicon epitaxial film having the carbon defects formed therein also exhibits excellent harmonic reduction capability due to the effect of the silicon epitaxial film. The inventive method for producing an epitaxial wafer and a method for producing a SOI wafer can readily produce the epitaxial wafer and the SOI wafer both exhibiting the excellent harmonic reduction capability, as described above.

In particular, even in a case where a silicon single crystal substrate having a normal resistivity is used, the excellent harmonic reduction capability can be exhibited, eliminating a need for using the high-resistivity substrate, and the production can be performed with fewer steps, and processing can be made easier.

### BRIEF DESCRIPTION OF DRAWINGS

[FIG. 1] is a flow diagram illustrating an example of a method for producing an epitaxial wafer according to the present invention.
[FIG. 2] is a flow diagram illustrating an example of a method for producing a SOI wafer according to the present invention.
[FIG. 3] is a planar TEM image including an interface between a silicon epitaxial film and a substrate when a carbon atom concentration in Experimental Example 1 is 7.0×10¹⁸ atoms/cm³.
[FIG. 4] is a cross-sectional TEM image including an interface between a silicon epitaxial film and a substrate when a carbon atom concentration in Experimental Example 1 is 7.0×10¹⁸ atoms/cm³.
[FIG. 5] is a planar TEM image including an interface between a silicon epitaxial film and a substrate when a carbon atom concentration in Experimental Example 1 is 2.0×10¹⁹ atoms/cm³.
[FIG. 6] shows lifetime measurement results for epitaxial wafers in Experimental Example 1 and Experimental Example 2.
[FIG. 7] is a graph showing a relationship between second-harmonic characteristics and a carbon atom concentration for epitaxial wafers in Experimental Example 1 and Experimental Example 2.

### DESCRIPTION OF EMBODIMENTS

Hereinafter, the present invention will be described in detail. However, the present invention is not limited thereto.

As described above, in response to demands for miniaturization, power saving, and cost reduction, in a communication device, an epitaxial wafer has been required, in which high-frequency characteristics can be further improved, and particularly, harmonics can be reduced.

The present inventors have earnestly studied this problem. First, under reduced pressure, a carbon-doped silicon epitaxial film having a thickness of 0.5 to 5.5 µm and a carbon atomic concentration of 5×10¹⁷ atoms/cm³ or more and less than 2×10¹⁹ atoms/cm³ is formed on a silicon single crystal substrate having a resistivity of 10 Ω·cm or more and 5000 Ω·cm or less in a gas atmosphere containing silicon and carbon (for example, monomethylsilane gas or trimethylsilane gas). Subsequently, in order to further achieve a greater reduction of harmonics, the epitaxial wafer having the carbon-doped silicon epitaxial film is subjected to heat treatment in an atmosphere at 900°C or more and 1100°C or less. Electrodes having a line length of 2200 µm are formed on these wafers to measure a second harmonic. As a result, it is found that the heat-treated wafer exhibits a superior reduction effect on the second harmonic compared to a sample that is not subjected to heat treatment.

Among these, when the silicon epitaxial film having a carbon atomic concentration of less than 2×10¹⁹ atoms/cm³ is used, it is found that defects other than carbon defects are not formed, and no risk exists that other types of defects in the wafer deteriorate device characteristics. In contrast, when the carbon atomic concentration is 2×10¹⁹ atoms/cm³ or more, it is confirmed that, when subjected to heat treatment, white defects that are not carbon defects are formed. Accordingly, it is preferable that the carbon atomic concentration is less than 2×10¹⁹ atoms/cm³.

The reason why the sample subjected to the heat treatment can exhibit the greater reduction in the second harmonic compared to the epitaxial wafer without heat treatment is that the carbon atomic concentration in the silicon epitaxial film is 5×10¹⁷ atoms/cm³ or more and less than 2×10¹⁹ atoms/cm³, which significantly exceeds the typical carbon solid solubility in silicon of 3×10¹⁷ atoms/cm³, which is considered to enable the formation of the carbon defects through the heat treatment. As a result of agglomeration of carbon atoms and to formation of carbon defects, new deep levels are formed in the silicon epitaxial film, leading to an increase in trap density compared to the state prior to heat treatment.

Based on these findings, it is found that the silicon epitaxial film, in which carbon defects are formed through the heat treatment, is effective as a trap-rich layer and can also be applied to a trap-rich SOI wafer used as a substrate for an active device.

The present inventors have arrived at the present invention based on the above-described findings. That is, one embodiment of the present invention is an epitaxial wafer comprising a silicon epitaxial film on a silicon single crystal substrate having a resistivity of 10 Ω·cm or more and 5000 Ω·cm or less, wherein
the silicon epitaxial film has a carbon atomic concentration of 5×10¹⁷ atoms/cm³ or more and less than 2×10¹⁹ atoms/cm³, and
carbon defects are formed in the silicon epitaxial film.

Moreover, another embodiment of the present invention is a method for producing an epitaxial wafer, the method comprising:
vapor phase growing a silicon epitaxial film having a carbon atomic concentration of 5×10¹⁷ atoms/cm³ or more and less than 2×10¹⁹ atoms/cm³ under reduced pressure on a silicon single crystal substrate having a resistivity of 10 Ω·cm or more and 5000 Ω·cm or less; and
thereafter subjecting the silicon epitaxial film to heat treatment under conditions of a heat treatment temperature of 900°C or more and 1100°C or less and a heat treatment time of one hour or more and 36 hours or less, thereby forming carbon defects in the silicon epitaxial film.

Hereinafter, the present invention will be described in detail with reference to the drawings. However, the present invention is not limited thereto.

### [Epitaxial Wafer and Method for Producing Same]

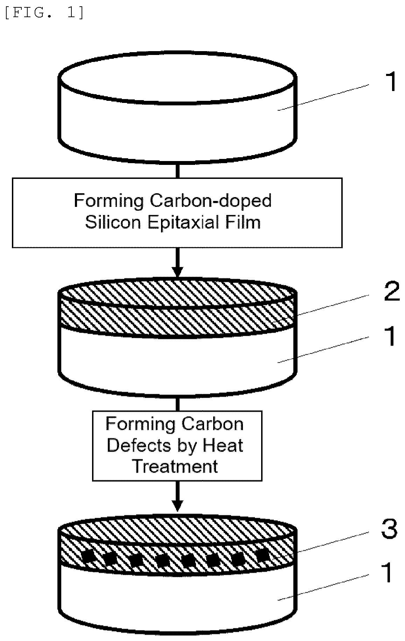

FIG. 1 shows an example of the inventive method for producing an epitaxial wafer. This method is a method for producing an epitaxial wafer using the silicon epitaxial film in which carbon defects are formed to serve as the trap-rich layer, as described above.

First, a silicon single crystal substrate 1 having a resistivity of 10 Ω·cm or more and 5000 Ω·cm or less is provided. Next, a silicon epitaxial film 2 (hereinafter, carbon-doped silicon epitaxial film) having a carbon atomic concentration of 5×10¹⁷ atoms/cm³ or more and less than 2×10¹⁹ atoms/cm³ is vapor-phase grown by supplying a gas containing a silicon atom and a carbon atom onto the silicon single crystal substrate under reduced pressure. Subsequently, by subjecting the epitaxial wafer having the carbon-doped silicon epitaxial film 2 to heat treatment, the carbon defects can be formed in the silicon epitaxial film.

By performing vapor-phase growth of the carbon-doped silicon epitaxial film 2 under reduced pressure, it is possible to reduce a concentration of an impurity other than carbon that is doped in the silicon epitaxial film. The pressure for forming the carbon-doped silicon epitaxial film 2 may simply be the reduced pressure and is not particularly limited, but it is preferably performed at approximately 10 Torr, for example, 5 Torr or more and 20 Torr or less (10 Torr corresponds approximately 1.3 kPa, 5 Torr or more and 20 Torr or less corresponds approximately 0.67 kPa or more and approximately 2.7 kPa or less).

As described above, the gas containing the silicon atom and the carbon atom (raw material gas) is used for the carbon doping in the vapor-phase growth of the carbon-doped silicon epitaxial film 2. As the raw material gas, it is preferable to use a gas containing at least one of the monomethylsilane gas and the trimethylsilane gas. By using these gases, excellent carbon doping can be readily performed in the silicon epitaxial film. Moreover, hydrogen, argon, or the like may be contained in the atmosphere during the vapor-phase growth as a carrier gas upon supplying the raw material gas.

By vapor-phase growing the carbon-doped silicon epitaxial film under reduced pressure, at 600 to 1000°C, the carbon-doped silicon epitaxial film 2 can be excellently formed.

Moreover, it is preferable to appropriately set the pressure, temperature, time, and raw material gas concentration during the vapor-phase growth such that the thickness of the carbon-doped silicon epitaxial film 2 to be formed becomes a desired thickness. While the upper limit and the lower limit of the thickness of the carbon-doped silicon epitaxial film are not particularly limited, the thickness can be, for example, 0.1 µm or more and 10 µm or less in consideration of productivity and cost. Such a film can have sufficiently high-frequency characteristics at a lower cost. In addition, the thickness can be more suitably set to 0.5 µm or more and 5.5 µm or less, but it is not limited thereto.

The method of heat treatment after forming the carbon-doped silicon epitaxial film 2 is not particularly limited, and for example, a typical heat treatment furnace for a silicon wafer or a chamber used for vapor-phase growth of the carbon-doped silicon epitaxial film can be used.

The lower limit of the heat treatment temperature during the heat treatment can be 900°C or more. This promotes the formation of the carbon defects, and production efficiency is improved. Moreover, the heat treatment time can be one hour or more. This enables sufficient carbon defects to be formed, and product quality is improved. The upper limit of the heat treatment temperature can be 1100°C or lower. This can suppress an effect of heavy metal diffusion. The upper limit of the heat treatment time can be 36 hours or shorter. This results in the epitaxial wafer that is excellent from a perspective of production efficiency.

In light of the foregoing, the epitaxial wafer is directly loaded into the heat treatment furnace that is heated to the heat treatment temperature of 900°C or more and 1100°C or less, and the heat treatment is performed under the conditions of the heat treatment time of one hour or more and 36 hours or less, thereby the carbon defects are formed in the silicon epitaxial film grown by vapor-phase growth under reduced pressure. In this case, the type of gas used during the heat treatment can be used differently according to an intended application, for example, oxygen gas or inert gases such as argon and nitrogen.

In this way, the inventive epitaxial wafer can be produced. A silicon epitaxial film 3, in which the carbon defects are formed therein by the heat treatment, functions as the trap-rich layer.

Among these, when the carbon atomic concentration is 5×10¹⁷ atoms/cm³ or more and less than 2×10¹⁹ atoms/cm³, a sufficient number of carbon defects are formed by the heat treatment, and thus, the second harmonic can be reduced more than before the heat treatment. In contrast, when the carbon atomic concentration contained in the silicon epitaxial film is 2×10¹⁹ atoms/cm³ or more, defects other than the carbon defects are abundantly formed after the heat treatment, resulting in deterioration of quality.

By setting the resistivity of the silicon single crystal substrate 1, on which the carbon-doped silicon epitaxial film 2 is formed, to 10 Ω·cm or more and 5000 Ω·cm or less, as described above, the resulting epitaxial wafer can be suitably used as a wafer for a high-frequency device. In particular, the resistivity of 1000 Ω·cm or more and 5000 Ω·cm or less is more preferable, as high-frequency characteristics are excellent and the resistivity can be controlled during crystal fabrication.

In this way, the inventive epitaxial wafer is suitable for the wafer for a high-frequency device.

Note that Patent Document 3 discloses a wafer in which a carbon-doped epitaxial film is formed on a silicon single-crystal substrate.

Patent Document 3 discloses an epitaxial film containing a high concentration of carbon; however, an envisaged application differs, and a structure, production process, and resistivity differ. The present invention is envisaged to be used as the wafer for a high-frequency device. Patent Document 3 mainly envisages an image sensor. Accordingly, the wafer of the present invention has a two-layer structure composed of the silicon single crystal substrate 1 and the silicon epitaxial film 3 in which carbon defects are formed, or a SOI structure described later. In contrast, the wafer disclosed in Patent Document 3 is produced in at least a three-layer structure including a silicon single crystal substrate, a carbon-doped epitaxial film, and a silicon epitaxial film. Moreover, when focusing on a heat treatment process, the present invention forms the silicon epitaxial film 3 in which the carbon defects are formed by performing the heat treatment, after forming the carbon-doped silicon epitaxial film 2 by vapor-phase growth under reduced pressure. In addition, when producing the SOI structure, two substrates produced by different processes are bonded to produce the SOI structure. On the other hand, the wafer in Patent Document 3 is characterized in that a forming step using a conventional epitaxial growth furnace requires a temperature of 750°C or more, and a heat treatment step after forming a film is not included. In addition, when forming the multi-layer structure, a bonding step is not required.

When focusing on the resistivity required, the present invention is characterized in that the silicon single crystal substrate 1 has a resistivity broadly applicable in a wide range of 10 Ω·cm or more and 5000 Ω·cm or less. In contrast, the wafer disclosed in Patent Document 3 is characterized in that, for improving a performance of the image sensor, at least one of a silicon epitaxial underlying layer, the carbon-doped epitaxial film, and a silicon single-crystal film is a low resistivity film having a specific resistance of 1 Ω·cm or less, which is clearly distinct. Furthermore, the wafer disclosed in Patent Document 3 does not have a trap-rich layer function in the epitaxial film, and thus, application to the wafer for a high-frequency device is difficult.

As described above, according to the embodiment of the present invention, the epitaxial wafer can be provided, in which the epitaxial wafer includes the silicon epitaxial film on the silicon single crystal substrate 1 having a resistivity of 10 Ω·cm or more and 5000 Ω·cm or less, in which the silicon epitaxial film has a carbon atomic concentration of 5×10¹⁷ atoms/cm³ or more and less than 2×10¹⁹ atoms/cm³, and the carbon defects are formed in the silicon epitaxial film.

Moreover, such an epitaxial wafer is suitable for the wafer for a high-frequency device.

In addition, according to the embodiment of the present invention, the method for producing an epitaxial wafer can be provided, the method includes vapor phase growing the silicon epitaxial film having the carbon atomic concentration of 5×10¹⁷ atoms/cm³ or more and less than 2×10¹⁹ atoms/cm³ under reduced pressure on the silicon single crystal substrate 1 having a resistivity of 10 Ω·cm or more and 5000 Ω·cm or less, and thereafter subjecting the silicon epitaxial film to the heat treatment under conditions of a heat treatment temperature of 900°C or more and 1100°C or less and a heat treatment time of one hour or more and 36 hours or less, thereby forming the carbon defects in the silicon epitaxial film.

Moreover, the method for producing an epitaxial wafer, which is suitable for a wafer for a high-frequency device, can be provided.

### [SOI Wafer and Method for Producing Same]

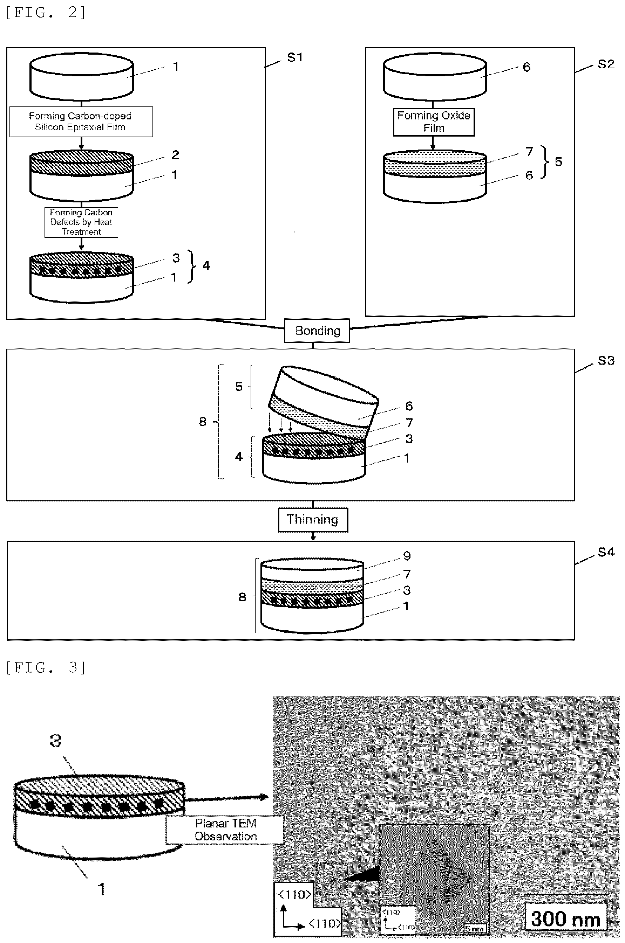

Subsequently, a method for producing a SOI wafer will be described. FIG. 2 shows an example of the inventive method for producing a SOI wafer.

In particular, Step S1 in FIG. 2 is a Step for producing an epitaxial wafer (first substrate 4) in which carbon defects are formed, and corresponds to the same Step in the method for producing an epitaxial wafer shown in FIG. 1.

Here, the epitaxial wafer (first substrate 4), having the silicon epitaxial film 3 in which the carbon defects are formed, serves as a base wafer in bonding.

Moreover, apart from the above epitaxial wafer, a second substrate 5 is provided in Step S2 in FIG. 2. The second substrate 5 can be produced by first providing a silicon single crystal substrate 6 and forming a dielectric layer 7 on a surface of the substrate 6. The silicon single crystal substrate 6 can be, for example, a silicon single crystal substrate 6 having a resistivity of approximately 10 Ω·cm, but is not limited thereto. As the dielectric layer 7, an oxide film, or the like, can be formed. When the oxide film is formed as this dielectric layer 7, the oxide film can be formed across an entire surface of the substrate by thermal oxidation. The second substrate 5 serves as a bond wafer.

The resistivity of the silicon single crystal substrate 6 on which the dielectric layer 7 is formed can be determined according to specifications of the device to be produced. On the other hand, the resistivity of the silicon single crystal substrate 1 on which the carbon-doped silicon epitaxial film 2 is formed is 10 Ω·cm or more and 5000 Ω·cm or less, as described above.

An order of Step S1 for producing the first substrate 4 and Step S2 for producing the second substrate 5 in FIG. 2 is irrelevant. Either Step may be performed first, or both Steps may be performed in parallel.

After providing the first substrate 4 and the second substrate 5 as described above, in Step S3 in FIG. 2, the silicon epitaxial film 3 which has carbon defects formed therein and is formed the epitaxial wafer serving as the first substrate 4, and the silicon single crystal substrate 6 which serves as the second substrate 5 and has the dielectric layer 7 on the surface are bonded (joined) together via the dielectric layer 7. In this manner, a SOI wafer 8 can be produced.

Moreover, after bonding, in Step S4 in FIG. 2, a portion of the silicon single crystal substrate 6 on the dielectric layer 7 (for example, oxide film) side can be thinned. This thinning can be performed by methods such as polishing or etching, or applying an ion implantation separation method to the silicon single crystal substrate 6 on the dielectric layer 7 (for example, oxide film) side to have a desired thickness according to an application. The ion implantation separation method can be performed, for example, by implanting, e.g., hydrogen ions into the silicon single crystal substrate 6 from the dielectric layer 7 side before bonding in FIG. 2 to form an ion-implanted layer in the silicon single crystal substrate 6 and after the bonding, by separating the substrate 6 along the ion implanted layer with performing the heat treatment, or the like. Through the above processes, a thinned silicon single crystal film 9 (silicon single crystal film) can be obtained.

In this way, the inventive SOI wafer 8 can be produced. The inventive SOI wafer 8 has a structure in which, in the following order: the silicon single crystal substrate 1 having a resistivity of 10 Ω·cm or more and 5000 Ω·cm or less; on the substrate 1, the silicon epitaxial film 3 in which the carbon defects are formed by heat treating the carbon-doped silicon epitaxial film 2 containing carbon at a concentration of 5×10¹⁷ atoms/cm³ or more and less than 2×10¹⁹ atoms/cm³; the dielectric layer 7; and the silicon single crystal film 9. In this case, the silicon epitaxial film 3, in which the carbon defects are formed, functions as the trap-rich layer. Therefore, the inventive SOI wafer 8 is suitable as the wafer for a high-frequency device.

As described above, according to the embodiment of the present invention, the epitaxial wafer includes the silicon epitaxial film on the silicon single crystal substrate 1 having a resistivity of 10 Ω·cm or more and 5000 Ω·cm or less, in which the silicon epitaxial film has a carbon atomic concentration of 5×10¹⁷ atoms/cm³ or more and less than 2×10¹⁹ atoms/cm³, and the carbon defects are formed in the silicon epitaxial film. Accordingly, the SOI wafer 8 can be provided, which includes a structure in which, on the silicon epitaxial film 3, in which carbon defects are formed in the film, the dielectric layer 7 and the silicon single crystal film 9 are formed in this order.

Moreover, such a SOI wafer 8 is suitable as the wafer for a high-frequency device.

Moreover, according to the embodiment of the present invention, the method for producing a SOI wafer 8 can be provided, which includes producing the epitaxial wafer by the method for producing an epitaxial wafer, the method including vapor phase growing a silicon epitaxial film having a carbon atomic concentration of 5×10¹⁷ atoms/cm³ or more and less than 2×10¹⁹ atoms/cm³ under reduced pressure on the silicon single crystal substrate 1 having a resistivity of 10 Ω·cm or more and 5000 Ω·cm or less, and thereafter subjecting the silicon epitaxial film to the heat treatment under conditions of a heat treatment temperature of 900°C or more and 1100°C or less and a heat treatment time of one hour or more and 36 hours or less, thereby forming carbon defects in the silicon epitaxial film. The method for producing a SOI wafer 8 further includes bonding the silicon epitaxial film 3 of the epitaxial wafer, in which carbon defects are formed, to the silicon single crystal substrate 6 having the dielectric layer 7 formed on a surface, via the dielectric layer 7.

Moreover, the method for producing a SOI wafer 8, which is suitable for the wafer for a high-frequency device, can be provided.

### [Harmonic Characteristics]

Measurements of harmonic characteristics of the epitaxial wafer and the SOI wafer are described.

### "In Case of SOI Wafer"

The measurement of harmonic characteristics of the SOI wafer is performed as follows. In order to measure the second harmonic characteristics (2HD characteristics), the topmost silicon single crystal film is first removed, and a Co-planar Waveguide (CPW) is then formed with a metal (such as aluminum) on the dielectric layer (such as an oxide film), and then probes are grounded to both ends of the metal electrodes. Subsequently, a high-frequency signal is input from either end of the electrodes, and the second harmonic output from the other end is measured (for example, frequency of input signal: 1 GHz, input power: 15 dBm).

As a result, when the carbon defects are formed by the heat treatment in the carbon-doped silicon epitaxial film on the silicon single crystal substrate, trap density in the trap-rich layer is increased compared to before the heat treatment. Consequently, carrier capture capability is improved, and excellent second harmonic characteristics can be obtained even when the silicon single crystal substrate does not have high resistivity.

The harmonic characteristics are improved as the thickness of the silicon epitaxial film, in which carbon defects are formed, increases.

### "In Case of Epitaxial Wafer"

The measurement of harmonic characteristics of the epitaxial wafer is performed as follows. When second harmonic characteristics of the epitaxial wafer having the silicon epitaxial film, in which the carbon defects are formed by the heat treatment, are measured after forming the carbon-doped silicon epitaxial film on the silicon single crystal substrate, a Co-planar Waveguide (CPW) is formed with a metal (such as aluminum) on the silicon epitaxial film, in which the carbon defects are formed, and then probes are grounded to both ends of the metal electrodes as in the same procedure described above. Subsequently, a high-frequency signal is input from either end of the electrodes, and the second harmonic output from the other end is measured (for example, frequency of input signal: 1 GHz, input power: 15 dBm).

As a result, as in the case of the SOI wafer, when the carbon defects are formed by the heat treatment in the carbon-doped silicon epitaxial film on the silicon single crystal substrate, the trap density in the trap-rich layer is increased compared to before the heat treatment. Consequently, carrier capture capability is improved, and excellent second harmonic characteristics can be obtained even when the silicon single crystal substrate does not have high resistivity.

In this way, the inventive epitaxial wafer and the inventive SOI wafer can improve the second-harmonic characteristics, therefore suitable for the wafer for a high-frequency device.

### EXAMPLES

Hereinafter, the present invention will be more specifically described referring to Experimental Example 1 to Experimental Example 4. However, the present invention is not limited thereto.

### (Experimental Example 1)

The inventive epitaxial wafer was produced in accordance with FIG. 1. A silicon single crystal substrate 1 having a diameter of 300 mm was obtained by slicing an ingot produced by a Czochralski method. On the silicon single crystal substrate 1, a carbon-doped silicon epitaxial film 2 (carbon atomic concentration: 2.0×10¹⁸ to 2.0×10¹⁹ atoms/cm³, and a film thickness: 5.5 µm) was formed using monomethylsilane as a raw material gas for carbon, using a low-pressure CVD apparatus. After the film formation, the obtained epitaxial wafer was subjected to heat treatment under an oxygen atmosphere, at 1000°C for 12 hours, thereby forming carbon defects in the silicon epitaxial film.

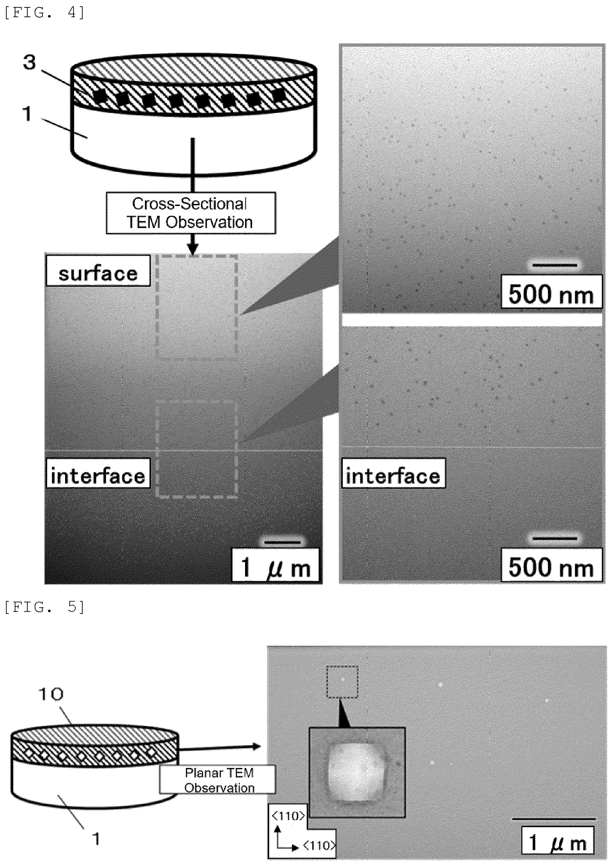

In order to investigate a structure of the epitaxial wafer, TEM observations were performed after the heat treatment using an epitaxial wafer having a carbon atomic concentration of 7.0×10¹⁸ atoms/cm³ during the film formation and an epitaxial wafer having a carbon atomic concentration of 2.0×10¹⁹ atoms/cm³. In the TEM observations, a TEM image (FIG. 3) in a plan direction and a TEM image (FIG. 4) in a cross-sectional direction were obtained, respectively, in which the TEM image in the plan direction includes an interface between a silicon epitaxial film 3 where carbon defects were formed therein and the silicon single crystal substrate 1, and the TEM image in the cross-sectional direction includes a surface of the silicon epitaxial film 3 where the carbon defects were formed therein, and an interface between the silicon epitaxial film 3 where the carbon defects were formed therein and the silicon single crystal substrate 1. Here, FIG. 3 is the planar TEM image of a thin sample (thickness of approximately 500 nm) sliced at a depth position including the interface between the silicon epitaxial film and the substrate, FIG. 4 is the cross-sectional TEM image of a thin sample (thickness of approximately 500 nm) sliced to include the interface between the silicon epitaxial film and the substrate. As a result, in the epitaxial wafer in which the carbon atomic concentration was set to 7.0×10¹⁸ atoms/cm³ during the film formation, it was found that performing heat treatment after the film formation led to the formation of black carbon defects throughout the entire silicon epitaxial film.

In contrast, in the epitaxial wafer in which the carbon atomic concentration was set to 2.0×10¹⁹ atoms/cm³ during the film formation, it was found that performing heat treatment after the film formation led to the formation of white defects that were not the carbon defects (appearance of a silicon epitaxial film 10 having white defects formed within) (see FIG. 5). Here, FIG. 5 is a planar TEM image of a thin sample (thickness of approximately 500 nm) sliced at a depth position including the interface between the silicon epitaxial film and the substrate.

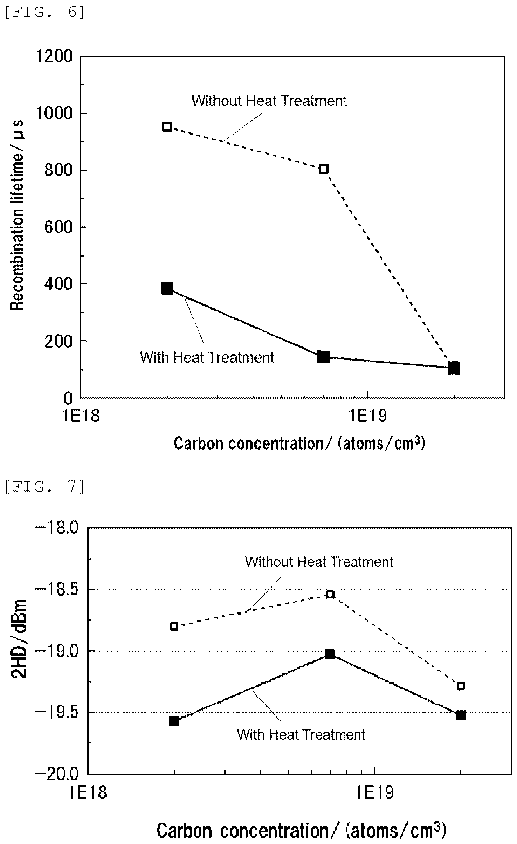

In order to investigate a trap density of the epitaxial wafer produced in Experimental Example 1 (carbon atomic concentration: 2.0×10¹⁸ to 2.0×10¹⁹ atoms/cm³, film thickness: 5.5 µm), a carrier lifetime was measured using a µ-PCD method. As a result, it was found that the carrier lifetimes of the epitaxial wafers in Experimental Example 1 were approximately 384 µs for a wafer having a carbon atomic concentration of 2.0×10¹⁸ atoms/cm³, approximately 145 µs for a wafer having a carbon atomic concentration of 7.0×10¹⁸ atoms/cm³, and approximately 106 µs for a wafer having a carbon atomic concentration of 2.0×10¹⁹ atoms/cm³ (see FIG. 6). Here, FIG. 6 is a lifetime measurement result of the epitaxial wafer in which the carbon defects were formed by heat treatment in Experimental Example 1 and an epitaxial wafer that was not subjected to heat treatment in Experimental Example 2 described later.

Subsequently, to investigate harmonic characteristics of the epitaxial wafer in Experimental Example 1, second-harmonic characteristics were measured. Aluminum electrodes having a line length of 2200 µm were formed on the silicon epitaxial film in which the carbon defects were formed, and the second-harmonic characteristics were measured. As a result, the second-harmonic characteristics when an input signal frequency was set to 1 GHz were approximately -19.6 dBm for a wafer having a carbon atomic concentration of 2.0×10¹⁸ atoms/cm³, approximately -19.0 dBm for a wafer having a carbon atomic concentration of 7.0×10¹⁸ atoms/cm³, and approximately -19.5 dBm for a wafer having a carbon atomic concentration of 2.0×10¹⁹ atoms/cm³. This result indicates that the epitaxial wafer in Experimental Example 1 can reduce a second harmonic (see FIG. 7). Here, FIG. 7 is a graph showing relationships between second-harmonic characteristics and carbon atom concentrations in the epitaxial wafer in which the carbon defects were formed by heat treatment in Experimental Example 1 and the epitaxial wafer that was not subjected to heat treatment in Experimental Example 2 described later.

### (Experimental Example 2)

An epitaxial wafer was produced in the same method as in the epitaxial wafer in Experimental Example 1, differing only in that heat treatment was not performed after film formation. First, a silicon single crystal substrate having a diameter of 300 mm was obtained by slicing an ingot produced by a Czochralski method. On the silicon single crystal substrate, a carbon-doped silicon epitaxial film (carbon atomic concentration: 2.0×10¹⁸ to 2.0×10¹⁹ atoms/cm³, and a film thickness: 5.5 µm) was formed using monomethylsilane as a raw material gas for carbon, using a low-pressure CVD apparatus, thereby providing the epitaxial wafer in Experimental Example 2.

In order to investigate a trap density of this epitaxial wafer, a carrier lifetime was measured using a µ-PCD method. As a result, it was found that the carrier lifetimes of the epitaxial wafer in Experimental Example 2 were approximately 953 µs for a wafer having a carbon atomic concentration of 2.0×10¹⁸ atoms/cm³, approximately 805 µs for a wafer of a carbon atomic concentration of 7.0×10¹⁸ atoms/cm³, and approximately 101 µs for wafer of a carbon atomic concentration of 2.0×10¹⁹ atoms/cm³. When Experimental Example 1 and Experimental Example 2 were compared with reference to FIG. 6, Experimental Example 1 achieved further reduction in carrier lifetime, and this result indicates that the trap density of the epitaxial wafer in Experimental Example 1 was significantly increased by heat treatment.

Subsequently, to investigate harmonic characteristics of this epitaxial wafer, second-harmonic characteristics were measured. Aluminum electrodes having a line length of 2200 µm were formed on the silicon epitaxial film, and the second-harmonic characteristics were measured. As a result, the second-harmonic characteristics when an input signal frequency was set to 1 GHz were approximately -18.8 dBm for a wafer having a carbon atomic concentration of 2.0×10¹⁸ atoms/cm³, approximately -18.5 dBm for a wafer having a carbon atomic concentration of 7.0×10¹⁸ atoms/cm³, and approximately -19.3 dBm for a wafer having a carbon atomic concentration of 2.0×10¹⁹ atoms/cm³. When Experimental Example 1 and Experimental Example 2 were compared with reference to FIG. 7, Experimental Example 1 achieved further reduction in the second-harmonic characteristics, and this result indicates that capability for reducing the second harmonic of the epitaxial wafer in Experimental Example 1 was significantly increased by heat treatment.

Based on the above results, it was found that the epitaxial wafer exhibiting excellent high-frequency characteristics can be obtained by producing the epitaxial wafer having the silicon epitaxial film in which the carbon-doped silicon epitaxial film had a carbon atomic concentration of 2×10¹⁸ atoms/cm³ or more and less than 2×10¹⁹ atoms/cm³, and carbon defects were formed therein by heat treatment.

### (Experimental Example 3)

In accordance with FIG. 2, the inventive SOI wafer was produced. First, an epitaxial wafer was provided, in which a carbon-doped silicon epitaxial film 2 (film thickness: 5.5 µm) having a carbon atomic concentration of 2×10¹⁸ atoms/cm³ or more and less than 2×10¹⁹ atoms/cm³ was formed on a silicon single crystal substrate 1 having a diameter of 300 mm under the same conditions as in Experimental Example 1. After formation, the epitaxial wafer obtained was subjected to heat treatment at 1000°C for 12 hours under an oxygen atmosphere, thereby forming carbon defects in the silicon epitaxial film. This wafer was used as a base wafer (first substrate 4). Separately, a silicon wafer was provided as a bond wafer (second substrate 5), in which an oxide film having a thickness of 400 nm was formed as a dielectric layer 7 on a surface of a silicon single crystal substrate 6 having a diameter of 300 mm. Next, a surface of a silicon epitaxial film 3 of the base wafer, in which carbon defects were formed, was bonded to the surface of the oxide film (surface of dielectric layer 7) of the bond wafer, and then by polishing the silicon single crystal substrate 6 on the bond wafer side, thereby producing a SOI wafer 8 with a 1 µm-thick silicon single crystal film remained.

### (Experimental Example 4)

An epitaxial wafer was produced in the same method as in the epitaxial wafer in Experimental Example 3, differing only in that heat treatment was not performed after forming a carbon-doped silicon epitaxial film. First, an epitaxial wafer was provided, in which a carbon-doped silicon epitaxial film 2 (film thickness: 5.5 µm) having a carbon atomic concentration of 2×10¹⁸ atoms/cm³ was formed on a silicon single crystal substrate 1 having a diameter of 300 mm under the same conditions as in Experimental Example 1. This wafer was used as a base wafer. Separately, a silicon wafer was provided as a bond wafer, in which an oxide film having a thickness of 400 nm was formed as a dielectric layer 7 on a surface of a silicon single crystal substrate 6 having a diameter of 300 mm. Next, a surface of a carbon-doped silicon epitaxial film 2 of the base wafer was bonded to a surface of an oxide film (surface of dielectric layer 7) of the bond wafer, and then by polishing the silicon single crystal substrate 6 on the bond wafer side, thereby producing a SOI wafer 8 with a 1 µm-thick silicon single crystal film remained.

After polishing to remove these single crystal layers of the SOI wafers (in Experimental Example 3 and Experimental Example 4) and exposing the oxide film layers, aluminum electrodes having a line length of 2200 µm were formed on the oxide films. As a result of measurements of second-harmonic characteristics in the same procedure as in Experimental Example 1, it was found that the SOI wafer (in Experimental Example 3) had better second-harmonic characteristics, approximately -1 dB better than those of the SOI wafer (in Experimental Example 4). Based on these results, it was found that the SOI wafer 8 having excellent high-frequency characteristics can be obtained by setting the carbon atomic concentration of the carbon-doped silicon epitaxial film to 2×10¹⁸ atoms/cm³ or more and less than 2×10¹⁹ atoms/cm³, and producing the SOI wafer 8 having the silicon epitaxial film 3, in which the carbon defects are formed by heat treatment, as shown in (Experimental Example 3).

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. An epitaxial wafer comprising a silicon epitaxial film on a silicon single crystal substrate having a resistivity of 10 Ω·cm or more and 5000 Ω·cm or less, wherein
the silicon epitaxial film has a carbon atomic concentration of 5×10¹⁷ atoms/cm³ or more and less than 2×10¹⁹ atoms/cm³, and
carbon defects are formed in the silicon epitaxial film.

2. The epitaxial wafer according to claim 1, wherein
the epitaxial wafer is a wafer for a high-frequency device.

3. A SOI wafer comprising a structure in which, on the silicon epitaxial film of the epitaxial wafer according to claim 1, a dielectric layer and a silicon single crystal film are formed in this order.

4. The SOI wafer according to claim 3, wherein
the SOI wafer is a wafer for a high-frequency device.

5. A method for producing an epitaxial wafer, the method comprising:
vapor phase growing a silicon epitaxial film having a carbon atomic concentration of 5×10¹⁷ atoms/cm³ or more and less than 2×10¹⁹ atoms/cm³ under reduced pressure on a silicon single crystal substrate having a resistivity of 10 Ω·cm or more and 5000 Ω·cm or less; and
thereafter subjecting the silicon epitaxial film to heat treatment under conditions of a heat treatment temperature of 900°C or more and 1100°C or less and a heat treatment time of one hour or more and 36 hours or less, thereby forming carbon defects in the silicon epitaxial film.

6. The method for producing an epitaxial wafer according to claim 5, wherein
the epitaxial wafer is a wafer for a high-frequency device.

7. A method for producing a SOI wafer, the method comprising:
producing the epitaxial wafer by the method according to claim 5; and
bonding a silicon epitaxial film of the epitaxial wafer to a silicon single crystal substrate having a dielectric layer formed on a surface, via the dielectric layer.

8. The method for producing a SOI wafer according to claim 7, wherein
the SOI wafer is a wafer for a high-frequency device.
